# EUROPÄISCHE PATENTANMELDUNG

(11) **EP 3 576 269 A1**
(43) Veröffentlichungstag der Anmeldung: **04.12.2019**
(21) Anmeldenummer: 18174802.1
(22) Anmeldetag: 29.05.2018
(51) Int. Cl.: H02M 1/08, H02M 3/158, H03K 17/082, H02M 1/00

(54) **ANSTEUERN EINES METALL-OXID-HALBLEITER-FELDEFFEKTTRANSISTORS**

(71) Anmelder: Siemens Aktiengesellschaft, 80333 München (DE)
(72) Erfinder: Bakran, Mark-Matthias, 91052 Erlangen (DE); Böhmer, Jürgen, 90547 Stein (DE); Helsper, Martin, 90584 Allersberg (DE); Krafft, Eberhard Ulrich, 90419 Nürnberg (DE); Laska, Bernd, 91074 Herzogenaurach (DE); Nagel, Andreas, 90431 Nürnberg (DE); Schönewolf, Stefan Hans Werner, 90489 Nürnberg (DE); Weigel, Jan, 91077 Großenbuch (DE)

(57) **Zusammenfassung**

Die Erfindung betrifft ein Verfahren und eine Ansteueranordnung (3) zum Ansteuern eines MOSFET (1), insbesondere eines auf einem Halbleiter mit breitem Bandabstand basierenden MOSFET (1). Erfindungsgemäß wird überwacht, ob die Bodydiode (2) des MOSFET (1) elektrisch leitend ist. Der MOSFET (1) wird eingeschaltet, wenn die Bodydiode (2) elektrisch leitend ist, und in Abhängigkeit von einem Ansteuersignal (S1) angesteuert, wenn die Bodydiode (2) elektrisch sperrend ist.

## Beschreibung

Die Erfindung betrifft ein Verfahren und eine Ansteueranordnung zum Ansteuern eines Metall-Oxid-Halbleiter-Feldeffekttransistors (MOSFET = Metal-Oxide-Semiconductor Field-Effect Transistor), insbesondere eines auf einem Halbleiter mit breitem Bandabstand (Wide-Bandgap Semiconductor) basierenden MOSFET.

Ein MOSFET ist rückwärts leitfähig und weist einen p-n-Übergang zwischen Bulk und Drain auf, der bei elektrischer Verbindung von Bulk und Source als eine intrinsische Diode wirkt, die als Inversdiode oder als Bodydiode des MOSFET bezeichnet wird. Rückwärtsströme fließen durch die Bodydiode, wenn der MOSFET ausgeschaltet ist. Da die Bodydiode einen hohen Widerstand aufweist, entstehen dabei hohe Verluste. Beträchtliche Verluste dieser Art können insbesondere in einem in MOSFET-Technologie ausgeführten Stromrichter auftreten, wenn in einem Fehlerfall alle MOSFET des Stromrichters ausgeschaltet werden und Rückwärtsströme aus einem mit dem Stromrichter verbundenen Versorgungsnetz oder einer mit dem Stromrichter verbundenen Last durch Bodydioden der MOSFET des Stromrichters fließen. Gegenwärtig werden in bestimmten Stromrichtern, beispielsweise in Traktionsstromrichtern, vermehrt MOSFET eingesetzt, die auf Halbleitern mit breitem Bandabstand, beispielsweise auf Siliciumcarbid oder Galliumnitrid, basieren und hohen Strombelastungen ausgesetzt sind. Insbesondere in diesen Stromrichtern entsteht daher das Problem, dass Rückwärtsströme durch die MOSFET bei einem fehlerbedingten Ausschalten aller MOSFET zu hohen Verlusten führen können.

Der Erfindung liegt die Aufgabe zugrunde, ein Verfahren und eine Ansteueranordnung zum Ansteuern eines MOSFET anzugeben, die hinsichtlich der Reduzierung von durch Rückwärtsströme verursachten Verlusten verbessert sind.

Die Aufgabe wird erfindungsgemäß durch ein Verfahren mit den Merkmalen des Anspruchs 1 und eine Ansteueranordnung mit den Merkmalen des Anspruchs 9 gelöst.

Vorteilhafte Ausgestaltungen der Erfindung sind Gegenstand der Unteransprüche.

Das erfindungsgemäßen Verfahren betrifft das Ansteuern eines MOSFET, insbesondere eines auf einem Halbleiter mit breitem Bandabstand basierenden MOSFET, mit einem Drain-Anschluss, einem Source-Anschluss, einem Gate-Anschluss und einer Bodydiode. Dabei wird überwacht, ob die Bodydiode elektrisch leitend ist. Der MOSFET wird eingeschaltet, wenn die Bodydiode elektrisch leitend ist, und der MOSFET wird in Abhängigkeit von einem Ansteuersignal angesteuert, wenn die Bodydiode elektrisch sperrend ist.

Die Erfindung sieht also vor, einen MOSFET einzuschalten, wenn seine Bodydiode leitend und somit stromführend ist. Durch das Einschalten des MOSFET werden Rückwärtsströme, die im ausgeschalteten Zustand des MOSFET allein durch die Bodydiode fließen würden, zumindest teilweise durch den MOSFET-Kanal zwischen dem Source-Anschluss und dem Drain-Anschluss geführt, so dass durch die Bodydiode fließende Rückwärtsströme und die dadurch verursachten Verluste stark reduziert werden. Wenn die Bodydiode elektrisch sperrend ist, wird der MOSFET wie üblich in Abhängigkeit von einem Ansteuersignal angesteuert, so dass die Ansteuerung des MOSFET in diesem Fall nicht geändert wird.

Eine Ausgestaltung der Erfindung sieht vor, dass ein erster Spannungs-Schwellenwert für eine Drain-Source-Spannung zwischen dem Drain-Anschluss und dem Source-Anschluss vorgegeben wird, die Drain-Source-Spannung erfasst wird und darauf geschlossen wird, dass die Bodydiode elektrisch leitend ist, wenn die Drain-Source-Spannung den ersten Spannungs-Schwellenwert unterschreitet. Ferner kann ein zweiter Spannungs-Schwellenwert für die Drain-Source-Spannung vorgegeben werden und darauf geschlossen werden, dass die Bodydiode elektrisch sperrend ist, wenn die Drain-Source-Spannung den zweiten Spannungs-Schwellenwert überschreitet. Beispielsweise sind beide Spannungs-Schwellenwerte negativ und der zweite Spannungs-Schwellenwert ist größer als der erste Spannungs-Schwellenwert.

Die vorgenannte Ausgestaltung der Erfindung nutzt die Drain-Source-Spannung, um zu erkennen, ob die Bodydiode elektrisch leitend oder sperrend ist. Dazu werden Spannungs-Schwellenwerte verwendet, deren Unter- beziehungsweise Überschreiten signalisieren, dass die Bodydiode elektrisch leitend beziehungsweise sperrend ist.

Eine weitere Ausgestaltung der Erfindung sieht vor, dass ein erster Strom-Schwellenwert für eine Drain-Source-Stromstärke eines in einer Durchlassrichtung der Bodydiode zwischen dem Drain-Anschluss und dem Source-Anschluss fließenden Drain-Source-Stroms vorgegeben wird, die Drain-Source-Stromstärke erfasst wird und darauf geschlossen wird, dass die Bodydiode elektrisch leitend ist, wenn die Drain-Source-Stromstärke den ersten Strom-Schwellenwert überschreitet. Ferner kann ein zweiter Strom-Schwellenwert für die Drain-Source-Stromstärke, der kleiner als der erste Strom-Schwellenwert ist, vorgegeben werden und darauf geschlossen werden, dass die Bodydiode elektrisch sperrend ist, wenn die Drain-Source-Stromstärke den zweiten Strom-Schwellenwert unterschreitet.

Eine weitere Ausgestaltung der Erfindung sieht vor, dass die Richtung eines zwischen dem Drain-Anschluss und dem Source-Anschluss fließenden Drain-Source-Stroms erfasst wird und darauf geschlossen wird, dass die Bodydiode elektrisch leitend ist, wenn der Drain-Source-Strom in einer Durchlassrichtung der Bodydiode fließt. Ferner kann darauf geschlossen werden, dass die Bodydiode elektrisch sperrend ist, wenn der Drain-Source-Strom entgegengesetzt zu der Durchlassrichtung der Bodydiode fließt.

Die vorgenannten Ausgestaltungen der Erfindung nutzen den Drain-Source-Strom, um zu erkennen, ob die Bodydiode elektrisch leitend oder sperrend ist. Dazu werden Strom-Schwellenwerte für die Stromstärke des Drain-Source-Stroms in der Durchlassrichtung der Bodydiode verwendet, deren Unter- beziehungsweise Überschreiten signalisieren, dass die Bodydiode elektrisch leitend beziehungsweise sperrend ist. Die Drain-Source-Stromstärke wird beispielsweise mit einem Shuntwiderstand gemessen, der in dem Strompfad des Drain-Source-Stroms angeordnet ist. Alternativ oder zusätzlich wird die Richtung des Drain-Source-Stroms erfasst, um zu erkennen, ob die Bodydiode elektrisch leitend oder sperrend ist. Die Richtung des Drain-Source-Stroms wird beispielsweise durch eine Zählung der ausgelösten Spannungsimpulse oder durch ein Flipflop, das bei jedem ausgelösten Spannungsimpuls seinen Zustand ändert, bestimmt.

Eine erfindungsgemäße Ansteueranordnung zur Durchführung des erfindungsgemäßen Verfahrens umfasst eine Überwachungseinheit, die dazu ausgebildet ist, zu ermitteln, ob die Bodydiode elektrisch leitend oder sperrend ist, und eine Steuereinheit, die dazu ausgebildet ist, den MOSFET einzuschalten, wenn die Überwachungseinheit ermittelt, dass die Bodydiode elektrisch leitend ist, und den MOSFET in Abhängigkeit von dem Ansteuersignal anzusteuern, wenn die Bodydiode elektrisch sperrend ist.

Ausgestaltungen der erfindungsgemäßen Ansteueranordnung sehen vor, dass die Überwachungseinheit dazu ausgebildet ist, die Drain-Source-Spannung zu erfassen und anhand der Drain-Source-Spannung zu ermitteln, ob die Bodydiode elektrisch leitend oder sperrend ist, oder/und dass die Überwachungseinheit dazu ausgebildet ist, die Drain-Source-Stromstärke zu erfassen und anhand der Drain-Source-Stromstärke zu ermitteln, ob die Bodydiode elektrisch leitend oder sperrend ist, oder/und dass die Überwachungseinheit dazu ausgebildet ist, die Richtung des Drain-Source-Stroms zu erfassen und anhand der Richtung des Drain-Source-Stroms zu ermitteln, ob die Bodydiode elektrisch leitend oder sperrend ist.

Eine weitere Ausgestaltung der erfindungsgemäßen Ansteueranordnung sieht vor, dass die Überwachungseinheit dazu ausgebildet ist, der Steuereinheit durch ein Zusatzansteuersignal mitzuteilen, ob die Bodydiode elektrisch leitend oder sperrend ist, und die Steuereinheit eine Endstufe zur Ansteuerung des MOSFET in Abhängigkeit von dem Zusatzansteuersignal und dem Ansteuersignal aufweist. Eine dazu alternative Ausgestaltung der erfindungsgemäßen Ansteueranordnung sieht vor, dass die Überwachungseinheit dazu ausgebildet ist, der Steuereinheit durch ein Zusatzansteuersignal mitzuteilen, ob die Bodydiode elektrisch leitend oder sperrend ist, und die Steuereinheit eine erste Endstufe zur Ansteuerung des MOSFET in Abhängigkeit von dem Ansteuersignal im Fall, dass die Bodydiode elektrisch sperrend ist, und eine zweite Endstufe zur Ansteuerung des MOSFET in Abhängigkeit von dem Zusatzansteuersignal im Fall, dass die Bodydiode elektrisch leitend ist, aufweist.

Eine erfindungsgemäße Ansteueranordnung ermöglicht die Durchführung des erfindungsgemäßen Verfahrens. Die Vorteile einer erfindungsgemäßen Ansteueranordnung entsprechen daher den oben bereits genannten Vorteilen des erfindungsgemäßen Verfahrens und werden hier nicht noch einmal gesondert aufgeführt.

Insgesamt modifiziert die Erfindung die Ansteuerung eines MOSFET nur in dem Fall, dass die Bodydiode elektrisch leitend ist. Dazu wird eine Ansteueranordnung verwendet, die die übliche Ansteuerung um die Zusatzfunktion erweitert, den MOSFET einzuschalten, wenn die Bodydiode elektrisch leitend ist. Abgesehen davon bleiben die übliche Ansteuerung des MOSFET und das übliche Schutzkonzept von der Erfindung unberührt.

Ein erfindungsgemäßer Stromrichter, insbesondere ein Traktionsstromrichter, weist wenigstens einen MOSFET, insbesondere einen auf einem Halbleiter mit breitem Bandabstand basierenden MOSFET, und eine erfindungsgemäße Ansteueranordnung zum Ansteuern des MOSFET auf. Die Erfindung eignet sich insbesondere für das Ansteuern eines MOSFET eines Traktionsstromrichters, da Strombelastungen eines MOSFET eines Traktionsstromrichters, insbesondere durch Rückwärtsströme, sehr hoch sein können und daher hohe Verluste verursachen können.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan eines MOSFET,
- FIG 2: einen Schaltplan eines MOSFET und eines ersten Ausführungsbeispiels einer Ansteueranordnung zum Ansteuern des MOSFET,
- FIG 3: ein Zusatzansteuersignal in Abhängigkeit von einer Drain-Source-Spannung eines MOSFET,
- FIG 4: einen Schaltplan eines Stromrichters,
- FIG 5: ein Ablaufdiagramm eines Verfahrens zum Ansteuern eines MOSFET.

Einander entsprechende Teile sind in den Figuren mit denselben Bezugszeichen versehen.

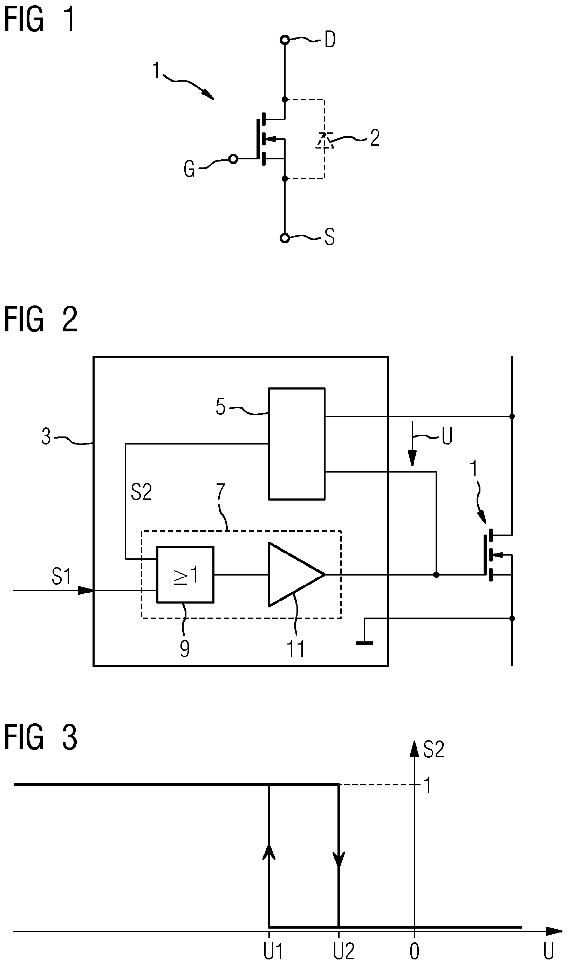

FIG 1 zeigt einen Schaltplan eines MOSFET 1 mit einem Drain-Anschluss D, einem Source-Anschluss S, einem Gate-Anschluss G und einer Bodydiode 2. Der MOSFET 1 ist als ein normal sperrender n-Kanal-MOSFET ausgebildet, der auf einem Halbleiter mit breitem Bandabstand, beispielsweise auf Siliciumcarbid oder Galliumnitrid, basiert. Rückwärtsströme, das heißt Ströme, die (gemäß technischer Stromrichtung) von dem Source-Anschluss S zu dem Drain-Anschluss D gerichtet sind, fließen im ausgeschalteten Zustand des MOSFET 1 durch die Bodydiode 2.

FIG 2 zeigt einen Schaltplan eines wie in FIG 1 ausgebildeten MOSFET 1 und eines ersten Ausführungsbeispiels einer erfindungsgemäßen Ansteueranordnung 3 zum Ansteuern des MOSFET 1.

Die Ansteueranordnung 3 umfasst eine Überwachungseinheit 5 und eine Steuereinheit 7. Die Überwachungseinheit 5 ist dazu ausgebildet, zu ermitteln, ob die Bodydiode 2 des MOSFET 1 elektrisch leitend oder sperrend ist, und dies der Steuereinheit 7 mitzuteilen. Dazu erfasst die Überwachungseinheit 5 eine Drain-Source-Spannung U zwischen dem Drain-Anschluss D und dem Source-Anschluss S des MOSFET 1 und gibt ein von der Drain-Source-Spannung U abhängiges binäres Zusatzansteuersignal S2 an die Steuereinheit 7 aus, das den Wert 0 oder den Wert 1 annimmt. Der Wert 1 des Zusatzansteuersignals S2 signalisiert, dass die Bodydiode 2 elektrisch leitend ist. Der Wert 0 des Zusatzansteuersignals S2 signalisiert, dass die Bodydiode 2 elektrisch sperrend ist.

FIG 3 zeigt das von der Überwachungseinheit 5 ausgegebene Zusatzansteuersignal S2 in Abhängigkeit von der Drain-Source-Spannung U. Das Zusatzansteuersignal S2 nimmt den Wert 1 an, wenn die Drain-Source-Spannung U einen vorgegebenen ersten Spannungs-Schwellenwert U1 unterschreitet. Das Zusatzansteuersignal S2 nimmt den Wert 0 an, wenn die Drain-Source-Spannung U einen vorgegebenen zweiten Spannungs-Schwellenwert U2 überschreitet. Beide Spannungs-Schwellenwerte U1, U2 sind negativ, wobei der zweite Spannungs-Schwellenwert U2 größer als der erste Spannungs-Schwellenwert U1 ist. Beispielsweise hat der erste Spannungs-Schwellenwert U1 einen Wert von etwa -1 V und der zweite Spannungs-Schwellenwert U2 hat einen Wert von etwa -0,5 V. Bei Werten der Drain-Source-Spannung U, die zwischen den beiden Spannungs-Schwellenwerten U1, U2 liegen, wird das Zusatzansteuersignal S2 nicht geändert, das heißt behält seinen momentanen Wert bei.

Die Steuereinheit 7 steuert den MOSFET 1 in Abhängigkeit von einem binären Ansteuersignal S1, das den Wert 0 oder den Wert 1 annimmt, und dem Zusatzansteuersignal S2 an. Dazu weist die Steuereinheit 7 ein Oder-Gatter 9 und eine Endstufe 11 auf. Dem Oder-Gatter 9 werden das Ansteuersignal S1 und das Zusatzansteuersignal S2 zugeführt. Das Oder-Gatter 9 gibt den Wert 0 an die Endstufe 11 aus, wenn sowohl das Ansteuersignal S1 als auch das Zusatzansteuersignal S2 den Wert 0 annehmen. Andernfalls gibt das Oder-Gatter 9 den Wert 1 an die Endstufe 11 aus. Wenn das Oder-Gatter 9 den Wert 1 ausgibt, schaltet die Endstufe 11 den MOSFET 1 ein, indem sie eine positive Einschaltspannung zwischen den Gate-Anschluss G und den Source-Anschluss S des MOSFET 1 legt. Andernfalls schaltet die Endstufe 11 den MOSFET 1 aus, indem sie eine Ausschaltspannung zwischen den Gate-Anschluss G und den Source-Anschluss S des MOSFET 1 legt.

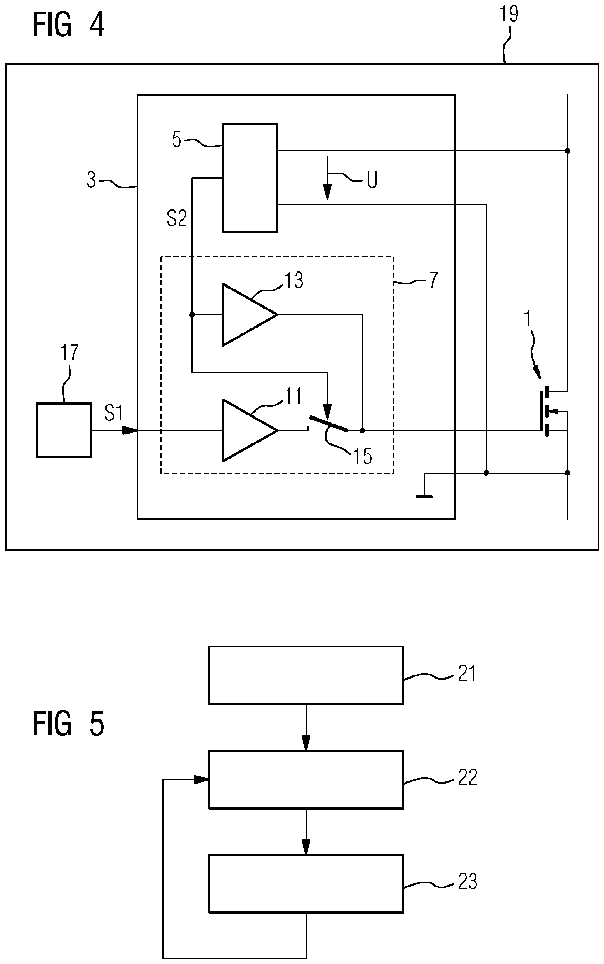

FIG 4 zeigt einen Schaltplan eines Stromrichters 19 mit einem MOSFET 1 und einem zweiten Ausführungsbeispiel einer erfindungsgemäßen Ansteueranordnung 3 zum Ansteuern des MOSFET 1. Der Stromrichter 19 ist beispielsweise ein Traktionsstromrichter mit weiteren (hier nicht dargestellten) MOSFET 1, die in bekannter Weise zu Halb- oder Vollbrücken verschaltet sind, und einer weiteren Ansteueranordnung 3 für jeden weiteren MOSFET 1.

Die Ansteueranordnungen 3 dieses Ausführungsbeispiels unterscheiden sich von dem in FIG 1 gezeigten Ausführungsbeispiel lediglich durch die Ausführung der Steuereinheiten 7. Eine Steuereinheit 7 dieses Ausführungsbeispiels weist zwei Endstufen 11, 13 und einen Schalter 15 auf. Einer ersten Endstufe 11 wird ein Ansteuersignal S1 zugeführt. Der zweiten Endstufe 13 wird das von der Überwachungseinheit 5 der jeweiligen Ansteueranordnung 3 ausgegebene Zusatzansteuersignal S2 zugeführt. Der Schalter 15 trennt einen Ausgang der ersten Endstufe 11 von dem Gate-Anschluss G des von der Ansteueranordnung 3 angesteuerten MOSFET 1, wenn das Zusatzansteuersignal S2 den Wert 1 annimmt. In diesem Fall wird der MOSFET 1 von der zweiten Endstufe 13 eingeschaltet, indem die zweite Endstufe 13 eine positive Einschaltspannung zwischen den Gate-Anschluss G und den Source-Anschluss S des MOSFET 1 legt. Wenn das Zusatzansteuersignal S2 den Wert 0 annimmt, wird der Ausgang der ersten Endstufe 11 durch den Schalter 15 mit dem Gate-Anschluss G des von der Ansteueranordnung 3 angesteuerten MOSFET 1 verbunden und der MOSFET 1 wird durch die erste Endstufe 11 angesteuert, das heißt von der zweiten Endstufe 13 wird keine Spannung zwischen den Gate-Anschluss G und den Source-Anschluss S des MOSFET 1 gelegt und der MOSFET 1 wird von der ersten Endstufe 11 eingeschaltet, wenn das Ansteuersignal S1 den Wert 1 annimmt, und ausgeschaltet, wenn das Ansteuersignal S1 den Wert 0 annimmt.

Die Ansteuersignale S1 für die MOSFET 1 des Stromrichters 19 werden von einer Steuerung 17 des Stromrichters 19 erzeugt. Es kann vorgesehen sein, dass die Ansteuerung der MOSFET 1 in Abhängigkeit von den Zusatzansteuersignalen S2 durch die zweiten Endstufen 13 nur aktiviert wird, wenn die Steuerung 17 dazu eine Freigabe erteilt.

FIG 5 zeigt ein Ablaufdiagramm eines Ausführungsbeispiels des erfindungsgemäßen Verfahrens zum Ansteuern eines MOSFET 1 mit einer gemäß FIG 2 oder FIG 4 ausgeführten Ansteueranordnung 3.

In einem ersten Verfahrensschritt 21 werden die Spannungs-Schwellenwerte U1, U2 für die Drain-Source-Spannung U vorgegeben.

In einem zweiten Verfahrensschritt 22 werden von der Überwachungseinheit 5 die Drain-Source-Spannung U erfasst und das Zusatzansteuersignal S2 in Abhängigkeit von der Drain-Source-Spannung U in der oben anhand von FIG 3 beschriebenen Weise gebildet und an die Steuereinheit 7 ausgegeben.

In einem dritten Verfahrensschritt 23 wird der MOSFET 1 von der Steuereinheit 7 eingeschaltet, das heißt es wird eine Einschaltspannung zwischen den Gate-Anschluss G und den Source-Anschluss S des MOSFET 1 gelegt, wenn das Zusatzansteuersignal S2 den Wert 1 annimmt. Andernfalls wird der MOSFET 1 von der Steuereinheit 7 in Abhängigkeit von dem Ansteuersignal S1 angesteuert, das heißt es wird die Einschaltspannung zwischen den Gate-Anschluss G und den Source-Anschluss S des MOSFET 1 gelegt, wenn das Ansteuersignal S1 den Wert 1 annimmt, oder eine Ausschaltspannung zwischen den Gate-Anschluss G und den Source-Anschluss S des MOSFET 1 gelegt, wenn das Ansteuersignal S1 den Wert 0 annimmt. Nach dem dritten Verfahrensschritt 23 wird das Verfahren mit dem zweiten Verfahrensschritt 22 fortgesetzt.

Die oben anhand der Figuren beschriebenen Ausführungsbeispiele einer erfindungsgemäßen Ansteueranordnung 3 und des erfindungsgemäßen Verfahrens können auf verschiedene Weisen zu alternativen Ausführungsbeispielen modifiziert werden. Insbesondere kann die Überwachungseinheit 5 in anderer Weise als in den oben anhand der Figuren beschriebenen Ausführungsbeispielen ausgebildet sein.

Beispielsweise kann die Überwachungseinheit 5 dazu ausgebildet sein, statt der Drain-Source-Spannung U eine Drain-Source-Stromstärke eines in einer Durchlassrichtung der Bodydiode 2 zwischen dem Drain-Anschluss D und dem Source-Anschluss S fließenden Drain-Source-Stroms zu erfassen und auszuwerten. In diesem Fall werden ein erster Strom-Schwellenwert für die Drain-Source-Stromstärke und ein zweiter Strom-Schwellenwert für die Drain-Source-Stromstärke, der kleiner als der erste Strom-Schwellenwert ist, vorgegeben. Das Zusatzansteuersignal S2 wird auf den Wert 1 gesetzt, wenn die Drain-Source-Stromstärke den ersten Strom-Schwellenwert überschreitet. Das Zusatzansteuersignal S2 wird auf den Wert 0 gesetzt, wenn die Drain-Source-Stromstärke den ersten Strom-Schwellenwert unterschreitet. Bei Werten der Drain-Source-Stromstärke, die zwischen den beiden Strom-Schwellenwerten liegen, wird das Zusatzansteuersignal S2 nicht geändert, das heißt behält seinen momentanen Wert bei.

Die Drain-Source-Stromstärke wird beispielsweise mit einem Shuntwiderstand gemessen, der in dem Strompfad des Drain-Source-Stroms angeordnet ist.

Alternativ kann die Überwachungseinheit 5 dazu ausgebildet sein, eine Richtung des Drain-Source-Stroms zu erfassen. In diesem Fall wird das Zusatzansteuersignal S2 auf den Wert 1 gesetzt, wenn der Drain-Source-Strom in der Durchlassrichtung der Bodydiode 2 fließt. Andernfalls wird das Zusatzansteuersignal S2 auf den Wert 0 gesetzt. Beispielsweise wird die Richtung des Drain-Source-Stroms unter Verwendung eines ferromagnetischen Kerns ermittelt, der bei jedem Richtungswechsel des Drain-Source-Stroms einen Spannungsimpuls auslöst. Die Richtung des Drain-Source-Stroms wird beispielsweise durch eine Zählung der ausgelösten Spannungsimpulse oder durch ein Flipflop, das bei jedem ausgelösten Spannungsimpuls seinen Zustand ändert, bestimmt.

Zu FIG 4 alternative Ausführungsbeispiele eines Stromrichters 19 ergeben sich durch Ersetzen der in FIG 4 gezeigten Ansteueranordnung 3 durch eine Ansteueranordnung 3 des in Figur 1 beschriebenen Ausführungsbeispiels oder eines der vorgenannten modifizierten Ausführungsbeispiele.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Ansteuern eines MOSFET (1), insbesondere eines auf einem Halbleiter mit breitem Bandabstand basierenden MOSFET (1), mit einem Drain-Anschluss (D), einem Source-Anschluss (S), einem Gate-Anschluss (G) und einer Bodydiode (2), wobei
- überwacht wird, ob die Bodydiode (2) elektrisch leitend ist,
- der MOSFET (1) eingeschaltet wird, wenn die Bodydiode (2) elektrisch leitend ist, und
- der MOSFET (1) in Abhängigkeit von einem Ansteuersignal (S1) angesteuert wird, wenn die Bodydiode (2) elektrisch sperrend ist.

2. Verfahren nach Anspruch 1, wobei ein erster Spannungs-Schwellenwert (U1) für eine Drain-Source-Spannung (U) zwischen dem Drain-Anschluss (D) und dem Source-Anschluss (S) vorgegeben wird, die Drain-Source-Spannung (U) erfasst wird und darauf geschlossen wird, dass die Bodydiode (2) elektrisch leitend ist, wenn die Drain-Source-Spannung (U) den ersten Spannungs-Schwellenwert (U1) unterschreitet.

3. Verfahren nach Anspruch 2, wobei ein zweiter Spannungs-Schwellenwert (U2) für die Drain-Source-Spannung (U) vorgegeben wird und darauf geschlossen wird, dass die Bodydiode (2) elektrisch sperrend ist, wenn die Drain-Source-Spannung (U) den zweiten Spannungs-Schwellenwert (U2) überschreitet.

4. Verfahren nach Anspruch 2 oder 3, wobei beide Spannungs-Schwellenwerte (U1,U2) negativ sind und der zweite Spannungs-Schwellenwert (U2) größer als der erste Spannungs-Schwellenwert (U1) ist.

5. Verfahren nach einem der vorhergehenden Ansprüche, wobei ein erster Strom-Schwellenwert für eine Drain-Source-Stromstärke eines in einer Durchlassrichtung der Bodydiode (2) zwischen dem Drain-Anschluss (D) und dem Source-Anschluss (S) fließenden Drain-Source-Stroms vorgegeben wird, die Drain-Source-Stromstärke erfasst wird und darauf geschlossen wird, dass die Bodydiode (2) elektrisch leitend ist, wenn die Drain-Source-Stromstärke den ersten Strom-Schwellenwert überschreitet.

6. Verfahren nach Anspruch 5, wobei ein zweiter Strom-Schwellenwert für die Drain-Source-Stromstärke, der kleiner als der erste Strom-Schwellenwert ist, vorgegeben wird und darauf geschlossen wird, dass die Bodydiode (2) elektrisch sperrend ist, wenn die Drain-Source-Stromstärke den zweiten Strom-Schwellenwert unterschreitet.

7. Verfahren nach einem der vorhergehenden Ansprüche, wobei die Richtung eines zwischen dem Drain-Anschluss (D) und dem Source-Anschluss (S) fließenden Drain-Source-Stroms erfasst wird und darauf geschlossen wird, dass die Bodydiode (2) elektrisch leitend ist, wenn der Drain-Source-Strom in einer Durchlassrichtung der Bodydiode (2) fließt.

8. Verfahren nach Anspruch 7, wobei darauf geschlossen wird, dass die Bodydiode (2) elektrisch sperrend ist, wenn der Drain-Source-Strom entgegengesetzt zu der Durchlassrichtung der Bodydiode (2) fließt.

9. Ansteueranordnung (3) zur Durchführung des Verfahrens nach einem der vorhergehenden Ansprüche, die Ansteueranordnung (3) umfassend
- eine Überwachungseinheit (5), die dazu ausgebildet ist, zu ermitteln, ob die Bodydiode (2) elektrisch leitend oder sperrend ist, und
- eine Steuereinheit (7), die dazu ausgebildet ist, den MOSFET (1) einzuschalten, wenn die Überwachungseinheit (5) ermittelt, dass die Bodydiode (2) elektrisch leitend ist, und den MOSFET (1) in Abhängigkeit von dem Ansteuersignal (S1) anzusteuern, wenn die Bodydiode (2) elektrisch sperrend ist.

10. Ansteueranordnung (3) nach Anspruch 9 und einem der Ansprüche 2 bis 4, wobei die Überwachungseinheit (5) dazu ausgebildet ist, die Drain-Source-Spannung (U) zu erfassen und anhand der Drain-Source-Spannung (U) zu ermitteln, ob die Bodydiode (2) elektrisch leitend oder sperrend ist.

11. Ansteueranordnung (3) nach Anspruch 9 und Anspruch 5 oder 6, wobei die Überwachungseinheit (5) dazu ausgebildet ist, die Drain-Source-Stromstärke zu erfassen und anhand der Drain-Source-Stromstärke zu ermitteln, ob die Bodydiode (2) elektrisch leitend oder sperrend ist.

12. Ansteueranordnung (3) nach Anspruch 9 und Anspruch 7 oder 8, wobei die Überwachungseinheit (5) dazu ausgebildet ist, die Richtung des Drain-Source-Stroms zu erfassen und anhand der Richtung des Drain-Source-Stroms zu ermitteln, ob die Bodydiode (2) elektrisch leitend oder sperrend ist.

13. Ansteueranordnung (3) nach einem der Ansprüche 9 bis 12, wobei die Überwachungseinheit (5) dazu ausgebildet ist, der Steuereinheit (7) durch ein Zusatzansteuersignal (S2) mitzuteilen, ob die Bodydiode (2) elektrisch leitend oder sperrend ist, und wobei die Steuereinheit (7) eine Endstufe (11) zur Ansteuerung des MOSFET (1) in Abhängigkeit von dem Zusatzansteuersignal (S2) und dem Ansteuersignal (S1) aufweist.

14. Ansteueranordnung (3) nach einem der Ansprüche 9 bis 12, wobei die Überwachungseinheit (5) dazu ausgebildet ist, der Steuereinheit (7) durch ein Zusatzansteuersignal (S2) mitzuteilen, ob die Bodydiode (2) elektrisch leitend oder sperrend ist, und wobei die Steuereinheit (7) eine erste Endstufe (11) zur Ansteuerung des MOSFET (1) in Abhängigkeit von dem Ansteuersignal (S1) im Fall, dass die Bodydiode (2) elektrisch sperrend ist, und eine zweite Endstufe (13) zur Ansteuerung des MOSFET (1) in Abhängigkeit von dem Zusatzansteuersignal (S2) im Fall, dass die Bodydiode (2) elektrisch leitend ist, aufweist.

15. Stromrichter (19), insbesondere Traktionsstromrichter, mit wenigstens einem MOSFET (1) und einer gemäß einem der Ansprüche 9 bis 14 ausgebildeten Ansteueranordnung (3) zum Ansteuern des MOSFET (1).
